(19) Europäisches Patentamt / European Patent Office / Office européen des brevets

(11) **EP 3 555 642 B1**

(12) **FASCICULE DE BREVET EUROPEEN**

(45) Date de publication et mention
de la délivrance du brevet:
**23.11.2022 Bulletin 2022/47**

(21) Numéro de dépôt: **17821617.2**

(22) Date de dépôt: **19.12.2017**

(51) Classification Internationale des Brevets (IPC):
**G01R 23/20** *(2006.01)*    **G01R 15/18** *(2006.01)*
**G01R 33/04** *(2006.01)*

(52) Classification Coopérative des Brevets (CPC):
**G01R 15/185; G01R 23/20;** G01R 33/04

(86) Numéro de dépôt international:
**PCT/EP2017/083671**

(87) Numéro de publication internationale:
**WO 2018/115032 (28.06.2018 Gazette 2018/26)**

(54) **CAPTEUR DE COURANT A VANNE DE FLUX**

STROMSENSOR MIT FLUXGATE

CURRENT SENSOR WITH FLUXGATE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **19.12.2016 FR 1662794**

(43) Date de publication de la demande:
**23.10.2019 Bulletin 2019/43**

(73) Titulaire: **Safran Electronics & Defense
92100 Boulogne-Billancourt (FR)**

(72) Inventeur: **GUILLOT, François
77550 MOISSY-CRAMAYEL (FR)**

(74) Mandataire: **Lavaud, Thomas et al
Cabinet Boettcher
16, rue Médéric
75017 Paris (FR)**

(56) Documents cités:
**EP-A1- 0 137 347        EP-A1- 0 137 347
EP-A1- 1 746 430        WO-A1-91/13366
WO-A1-2016/016038      WO-A1-2016/016038
WO-A2-2014/047644      WO-A2-2014/047644
FR-A1- 2 942 880        US-A- 3 435 337
US-A1- 2008 252 289**

## Description

L'invention concerne le domaine des capteurs de courant à vanne de flux.

ARRIERE PLAN DE L'INVENTION

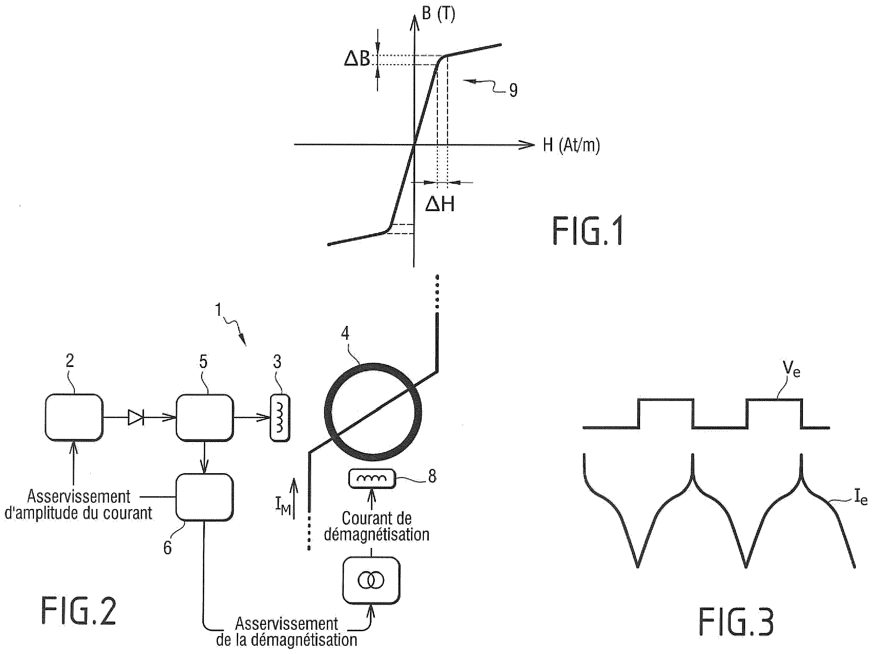

Un capteur de courant à vanne de flux utilise la propriété d'un matériau magnétique formant un noyau magnétique de se saturer à partir d'un certain niveau d'excitation magnétique. En référence à la figure 1, pour un champ magnétique H croissant, la pente de la fonction de transfert entre le champ magnétique H et l'induction magnétique B diminue grandement à partir d'une valeur dite de saturation du noyau magnétique. La valeur de saturation, sur la figure 1, correspond aux intervalles $\Delta$H et $\Delta$B.

En référence aux figures 2 et 3, dans un capteur de courant à vanne de flux classique 1 destiné à mesurer un courant Im circulant sur un conducteur, un générateur de signaux rectangulaires 2 applique une tension d'excitation rectangulaire Ve aux bornes d'un bobinage d'excitation 3 enroulé autour d'un noyau magnétique 4. Le courant d'excitation le circulant dans le bobinage d'excitation 3 est mesuré par un module de mesure 5. Un détecteur de crêtes 6, relié au module de mesure 5, fournit deux informations : le niveau de saturation et la différence des courants de crête du courant d'excitation le. Le niveau de saturation permet d'asservir l'amplitude de la tension d'excitation Ve. La différence des courants de crête du courant d'excitation Ie permet d'estimer le courant à mesurer Im et d'asservir, via un convertisseur de tension en courant 7, l'amplitude d'un courant de démagnétisation qui circule dans un bobinage de démagnétisation 8 et qui permet de compenser le flux magnétique produit dans le noyau magnétique 4 par le courant à mesurer Im.

Le document WO 2014/047644 A2 décrit un capteur de courant à vanne de flux fonctionnant par évaluation de la seconde harmonique de la fréquence fondamentale d'un signal d'excitation.

Les capteurs de courant à vanne de flux sont privilégiés dans un certain nombre d'applications. C'est notamment le cas pour la mesure d'un courant circulant dans un organe de coupure de type SSPC (pour « Solid State Power Controller ») à destination d'un équipement utilisateur, ou bien pour la mesure d'un courant circulant dans un organe de conversion d'énergie de type PEM (pour « Power Electronic Module ») relié à une phase d'un moteur.

Les capteurs de courant à vanne de flux classiques souffrent de quelques faiblesses. En particulier, la détection de crête est relativement sensible aux perturbations électromagnétiques externes, qui peuvent par conséquent dégrader la précision de la mesure du courant à mesurer. De plus, la détection de crête ne donne pas une information précise permettant l'asservissement sur le coude de saturation du noyau magnétique. Ceci est particulièrement problématique lorsque les perturbations électromagnétiques externes sont importantes, par exemple dans l'environnement d'un convertisseur de puissance à découpage. Il en est de même quand le capteur de courant à vanne de flux classique 1 est contraint par un environnement thermique difficile faisant dériver les caractéristiques intrinsèques du noyau magnétique.

Bien sûr, ce problème de précision est d'autant plus important que la plage en fréquence du courant à mesurer Im augmente (lorsque le courant à mesurer est un courant alternatif), ou bien lorsque la plage de température de fonctionnement du capteur de courant à vanne de flux augmente.

OBJET DE L'INVENTION

L'invention a pour objet d'améliorer la précision d'un capteur de courant à vanne de flux.

RESUME DE L'INVENTION

En vue de la réalisation de ce but, on propose un capteur de courant à vanne de flux comprenant un noyau magnétique qui s'étend autour d'un conducteur sur lequel circule un courant à mesurer, un bobinage d'excitation, un module d'excitation relié au bobinage d'excitation et destiné à générer une tension d'excitation aux bornes du bobinage d'excitation, un bobinage de mesure dans lequel circule un courant induit de mesure, un démodulateur synchrone de mesure relié au bobinage de mesure et destiné à multiplier le courant induit de mesure par un signal de démodulation de fréquence 2.f0 pour obtenir une tension image du courant à mesurer. La tension d'excitation est obtenue à partir d'une première tension de fréquence f0 et d'une deuxième tension de fréquence 3.f0. Le capteur de courant à vanne de flux comporte en outre un bobinage d'asservissement dans lequel circule un courant induit d'asservissement, et un démodulateur synchrone d'asservissement relié au bobinage d'asservissement et destiné à multiplier le courant induit d'asservissement par un signal de démodulation de fréquence 3.f0. Le démodulateur synchrone d'asservissement est relié au module d'excitation pour asservir la tension d'excitation de manière à annuler une composante de fréquence 3.f0 du courant induit d'asservissement.

Le capteur de courant à vanne de flux selon l'invention permet d'asservir précisément la tension d'excitation de manière à ce que le capteur de courant à vanne de flux fonctionne sur son point de fonctionnement optimal, correspondant au coude 9 de la fonction de transfert visible sur la figure 1. Le point de fonctionnement optimal correspond à un gain maximum du capteur de courant à vanne de flux. Le capteur de courant à vanne de flux est ainsi moins sensible aux perturbations électromagnétiques externes et donc plus précis.

L'invention sera mieux comprise à la lumière de la description qui suit d'un mode de mise en œuvre particulier non limitatif de l'invention.

BREVE DESCRIPTION DES DESSINS

Il sera fait référence aux dessins annexés, parmi lesquels :

- la figure 1 représente la courbe d'une fonction de transfert entre un champ magnétique et une induction magnétique ;
- la figure 2 représente un capteur de courant à vanne de flux selon l'art antérieur ;
- la figure 3 représente la courbe d'une tension d'excitation et la courbe d'un courant d'excitation qui excitent un noyau magnétique d'un capteur de courant à vanne de flux selon l'art antérieur ;
- la figure 4 représente un capteur de courant à vanne de flux selon l'invention ;
- la figure 5 représente un module d'excitation du capteur de courant à vanne de flux selon l'invention ;
- la figure 6 représente un exemple de démodulateur synchrone de mesure du capteur de courant à vanne de flux selon l'invention ;
- la figure 7 représente des courbes de tensions issues du capteur de courant à vanne de flux selon l'invention soumis au champ émis par un conducteur parcouru par un courant continu;
- la figure 8 représente une tension d'excitation utilisée dans le capteur de courant à vanne de flux selon l'invention ;
- la figure 9 représente un signal carré et un signal triangulaire ;
- la figure 10 représente un signal carré, un signal carré de fréquence triple, et la somme de ces signaux ;
- la figure 11 représente un exemple de circuit de dosage particulier du signal d'excitation ;
- la figure 12 représente une courbe d'une tension en sortie d'un démodulateur synchrone d'asservissement du capteur de courant à vanne de flux selon l'invention, en fonction d'une tension d'excitation.

DESCRIPTION DETAILLEE DE L'INVENTION

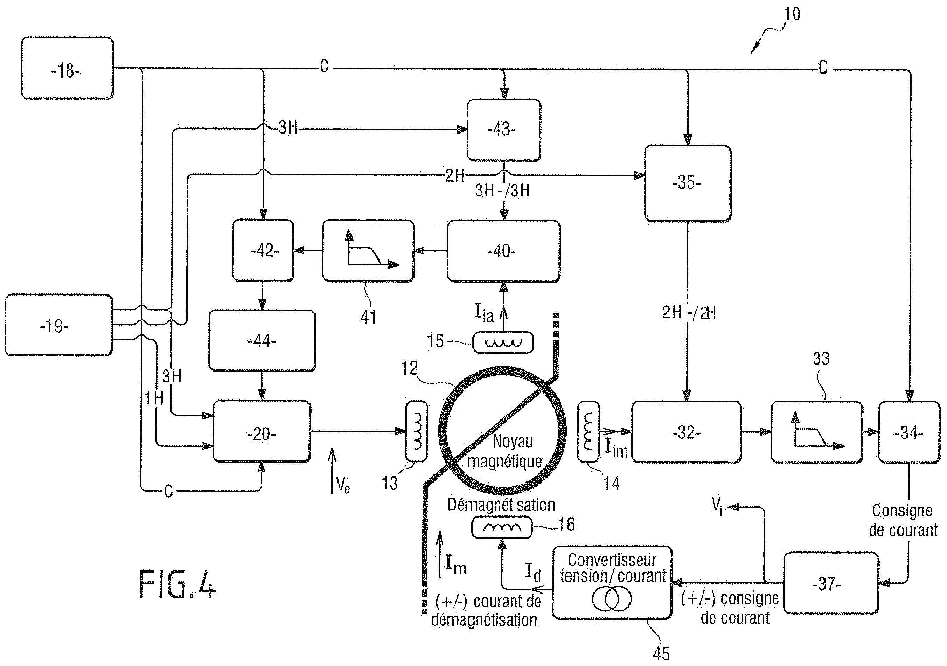

En référence à la figure 4, le capteur de courant à vanne de flux selon l'invention 10 est ici utilisé pour mesurer un courant à mesurer Im qui circule sur un conducteur 11.

Le capteur de courant à vanne de flux 10 comporte un transformateur comprenant un noyau magnétique 12 ainsi que quatre bobinages enroulés autour du noyau magnétique 12. Le noyau magnétique 12 s'étend autour du conducteur 11.

Les quatre bobinages comprennent un bobinage d'excitation 13, un bobinage de mesure 14, un bobinage d'asservissement 15 et un bobinage de démagnétisation 16. Le bobinage de mesure 14 et le bobinage d'asservissement 15 sont ici constitués chacun d'un enroulement double.

Le bobinage d'excitation 13 est utilisé pour exciter le noyau magnétique 12.

Le capteur de courant à vanne de flux 10 comporte de plus un générateur basse fréquence 18, un générateur haute fréquence 19 et un module d'excitation 20 qui est relié au bobinage d'excitation 13.

Le générateur basse fréquence 18 transmet un signal C aux deux démodulateurs 42, 43, 34 et 35. Le générateur haute fréquence 19 transmet au module d'excitation 20 un signal 1H à la fréquence f0 (en $\sin(\omega 0t)$, avec $\omega 0=2\Pi f0$), ainsi qu'un signal 3H à la fréquence 3.f0 (en $\sin(3\omega 0t)$, avec $\omega 0=2\Pi f0$).

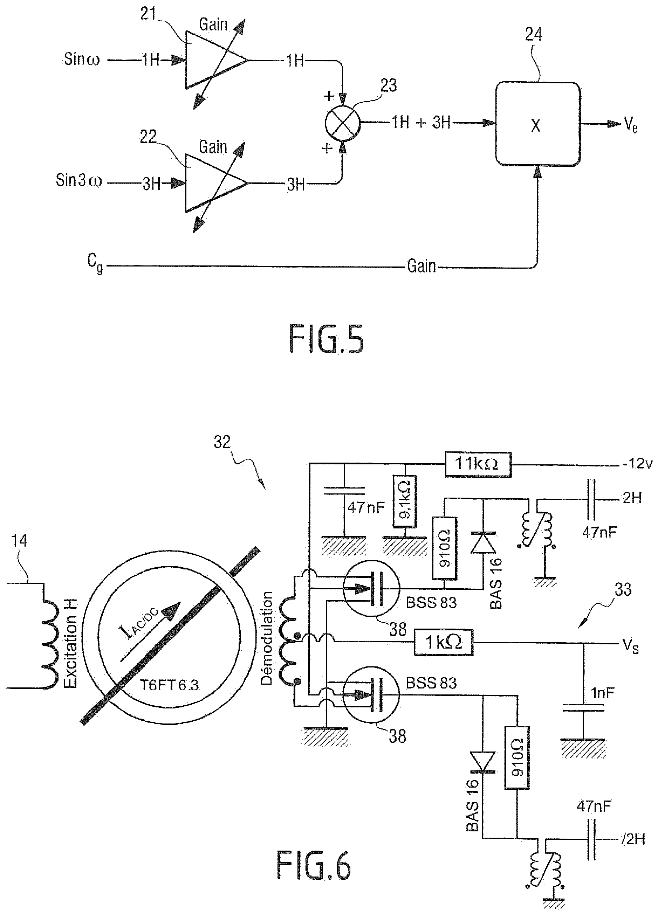

En référence à la figure 5, le module d'excitation 20 comporte une pluralité de blocs fonctionnels, parmi lesquels un premier bloc amplificateur 21 à gain variable, un deuxième bloc amplificateur 22 à gain variable, un bloc sommateur 23, un bloc de gain 24.

Le premier bloc amplificateur 21 reçoit le signal 1H à la fréquence f0, le deuxième bloc amplificateur 22 reçoit le signal 3H à la fréquence 3.f0, le bloc de gain 24 reçoit une consigne de gain Cg. Le bloc sommateur 23 additionne les sorties du premier bloc amplificateur 21 et du deuxième bloc amplificateur 22.

Le module d'excitation 20 permet ainsi de générer une tension d'excitation Ve à partir d'une première tension V1 de fréquence f0 et à partir d'une deuxième tension V2 de fréquence 3.f0.

Le bobinage de mesure 14 est utilisé pour mesurer le courant Im. Le capteur de courant à vanne de flux 10 comporte un démodulateur synchrone de mesure 32, un premier filtre passe-bas 33 et un premier bloc de gain unitaire 34, qui sont reliés en série avec le bobinage de mesure 14. Le premier bloc de gain unitaire 34 produit un gain sélectivement égal à 1 ou à -1. Le premier bloc de gain unitaire 34 reçoit un signal de découpage C du générateur basse fréquence 18. Le démodulateur synchrone de mesure 32 est relié à un premier bloc de sélection 35. Le premier bloc de sélection 35 reçoit du générateur basse fréquence 18 un signal de découpage C et du générateur haute fréquence 19 un signal 2H de fréquence 2.f0. Le premier bloc de sélection 35 produit un signal de démodulation de fréquence 2.f0 noté respectivement 2H- ou 2H selon qu'il est en phase ou en inversion de phase avec le signal 2H à la fréquence 2.f0.

Le signal de démodulation 2H-/2H est un signal en cos($2\omega_0 t$), où $\omega_0 = 2\Pi f_0$. Le démodulateur synchrone de mesure 32 multiplie par le signal de démodulation 2H-/2H un courant induit de mesure Iim circulant dans le bobinage de mesure 14 et induit par le courant à mesurer Im. Un premier correcteur proportionnel intégral 37, relié au premier bloc de gain unitaire 34, produit une tension image Vi du courant à mesurer Im.

En référence à la figure 6, le démodulateur synchrone de mesure 32 comporte un commutateur analogique utilisant des interrupteurs 38 rapides de type MOS. Le premier filtre passe-bas 33 est un filtre passif. Le commutateur analogique est cadencé par le signal de démodulation 2H-/2H en phase ou en inversion de phase. La tension Vs en sortie du premier filtre passe-bas 33 est une tension image de la composante harmonique d'ordre 2 de la tension d'excitation Ve.

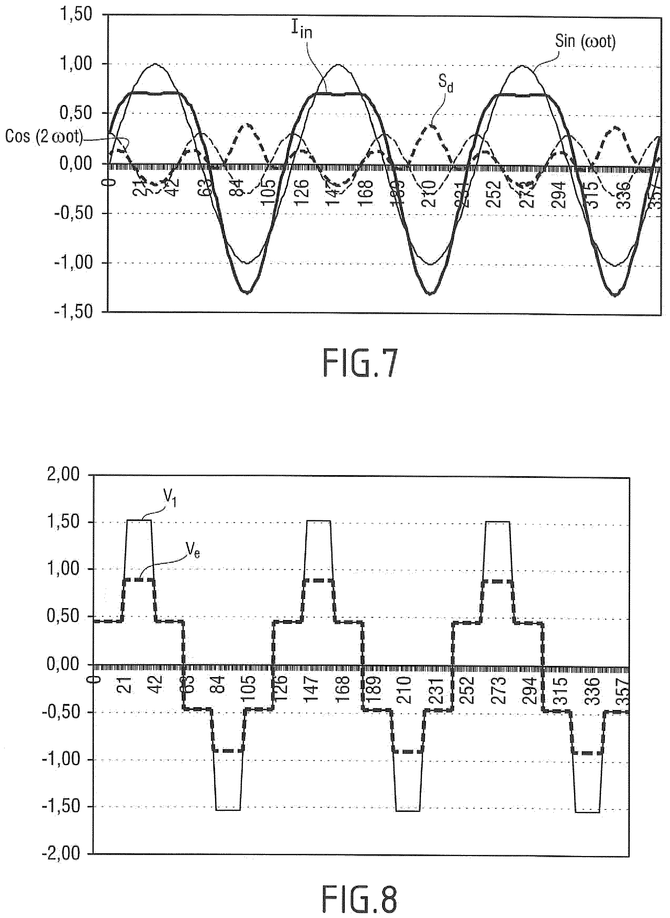

En référence à la figure 7, on note que la saturation du noyau magnétique 12 provoque une dissymétrie du courant induit de mesure Iim, ledit courant induit de mesure Iim étant constitué par la somme d'une composante de fréquence f0 en sin($\omega_0 t$), correspondant à la fondamentale, et d'une composante de fréquence 2.f0 en cos($2\omega_0 t$), correspondant à la composante harmonique d'ordre 2. La composante moyenne du signal démodulé Sd est non nulle et positive. En prenant l'opposé de la saturation, la composante moyenne du signal démodulé Sd devient négative.

Le bobinage d'asservissement 15, dans lequel circule un courant induit d'asservissement Iia, est utilisé pour contrôler la tension d'excitation Ve. Le capteur de courant à vanne de flux 10 comporte un démodulateur synchrone d'asservissement 40, un deuxième filtre passe-bas 41 et un deuxième bloc de gain unitaire 42, qui sont reliés en série avec le bobinage d'asservissement 15. Le deuxième bloc de gain unitaire 42 produit un gain sélectivement égal à 1 ou à -1. Le deuxième bloc de gain unitaire 42 reçoit un signal continu C du générateur basse fréquence 18. Le démodulateur synchrone d'asservissement 40 est relié à un deuxième bloc de sélection 43. Le deuxième bloc de sélection 43 reçoit du générateur basse fréquence 18 un signal de découpage C et du générateur haute fréquence un signal 3H de fréquence 3.f0. Le deuxième bloc de sélection 43 produit un signal de démodulation 3H-/3H de fréquence 3.f0 en phase ou en inversion de phase. Le signal de démodulation 3H-/3H est un signal en sin($3\omega_0 t$), où $\omega_0 = 2\Pi f_0$. Le démodulateur synchrone d'asservissement 40 multiplie par le signal de démodulation 3H-/3H le courant induit d'asservissement Iia. Un deuxième correcteur proportionnel intégral 44 est connecté entre le deuxième bloc de gain unitaire 42 et le module d'excitation 20. On asservit ainsi la tension d'excitation Ve de manière à annuler la composante de fréquence 3.f0 du courant induit d'asservissement Iia.

Le démodulateur synchrone d'asservissement 40 est semblable au démodulateur synchrone de mesure 32, visible sur la figure 6, si ce n'est que le commutateur analogique est cadencé par le signal de démodulation 3H-/3H en phase ou en inversion de phase.

Le bobinage de démagnétisation 16, quant à lui, est relié à la sortie du premier correcteur proportionnel intégral 37 via un convertisseur de tension en courant 45. Un courant de démagnétisation Id circule dans le bobinage de démagnétisation 16 pour démagnétiser le noyau magnétique 12.

La tension image Vi du courant à mesurer Im, en sortie du premier correcteur proportionnel intégral 37, est appliquée en entrée du convertisseur de tension en courant 45. Le convertisseur de tension en courant 45 produit le courant de démagnétisation Id à partir de la tension image Vi du courant à mesurer Im. Le courant en sortie du premier bloc de gain unitaire 34 forme une consigne de courant appliquée en entrée du premier correcteur proportionnel 37. On asservit ainsi le courant de démagnétisation Id à partir de la tension image Vi du courant à mesurer Im de manière à compenser le flux magnétique produit par le courant à mesurer Im.

On décrit maintenant plus en détail les caractéristiques de la tension d'excitation Ve.

En référence à la figure 8, l'amplitude de la première tension V1 et l'amplitude de la deuxième tension V2 sont réglées pour obtenir une tension d'excitation Ve dont la composante de fréquence 3.f0 (ou composante harmonique d'ordre 3) est en phase avec la composante de fréquence f0 (ou fondamentale).

La composante harmonique d'ordre 3 du courant induit d'asservissement Iia circulant dans le bobinage d'asservissement 15, obtenue après démodulation synchrone via le démodulateur synchrone d'asservissement 40, est positive. En cas de saturation du noyau magnétique 12, la composante harmonique d'ordre 3 est atténuée plus fortement que la fondamentale et la composante harmonique d'ordre 3 après démodulation synchrone devient négative, car l'harmonique d'ordre 3 passe en opposition de phase avec la fondamentale.

Ainsi, lorsque la tension d'excitation Ve est telle que le noyau magnétique 12 se rapproche de la saturation, le rapport de l'amplitude de la composante harmonique d'ordre 1 et de l'amplitude de la composante harmonique d'ordre 3 du courant induit d'asservissement Iia évolue jusqu'à annulation de la composante harmonique d'ordre 3, puis jusqu'à inversion de phase de la composante harmonique d'ordre 3. Le point de fonctionnement correspondant à l'annulation de la composante harmonique d'ordre 3 du courant induit d'asservissement Iia est donc un point de fonctionnement optimal du capteur de courant à vanne de flux 10. Ce point de fonctionnement optimal correspond au coude 9 de la courbe de fonction de transfert de la figure 1.

L'asservissement de la tension d'excitation Ve consiste donc à contrôler la tension d'excitation Ve, avant que celle-ci ne soit appliquée aux bornes du bobinage d'excitation 13, pour annuler la composante harmonique d'ordre 3 du courant induit d'asservissement Iia. Le capteur de courant à vanne de flux 10 fonctionne ainsi en permanence sur le point de fonctionnement optimal. On obtient de la sorte un gain maximal des dissymétries introduites par le courant à mesurer Im et détectables sur le courant induit de mesure Iim. On note que cet asservissement par démodulation synchrone de la composante harmonique d'ordre 3 est peu sensible aux perturbations électromagnétiques externes, car tous les signaux de fréquence différente de la fréquence 3.f0 génèrent des produits d'intermodulation dont les composantes sont filtrées par le premier filtre passe-bas 33 connecté en sortie du démodulateur synchrone de mesure 32. On note par ailleurs que cet asservissement n'a pas besoin d'être très rapide, car les variations provenant de paramètres extérieurs (température, vieillissement) sont relativement lentes.

Comme on le voit sur la figure 7, la première tension V1 et la deuxième tension V2 sont ici toutes deux des tensions rectangulaires. Les tensions rectangulaires sont en effet simples à générer, et présentent d'importantes composantes harmoniques impaires.

L'intérêt d'utiliser une telle tension d'excitation Ve constituée par une telle première tension V1 et une telle deuxième tension V2 découle de ce qui suit.

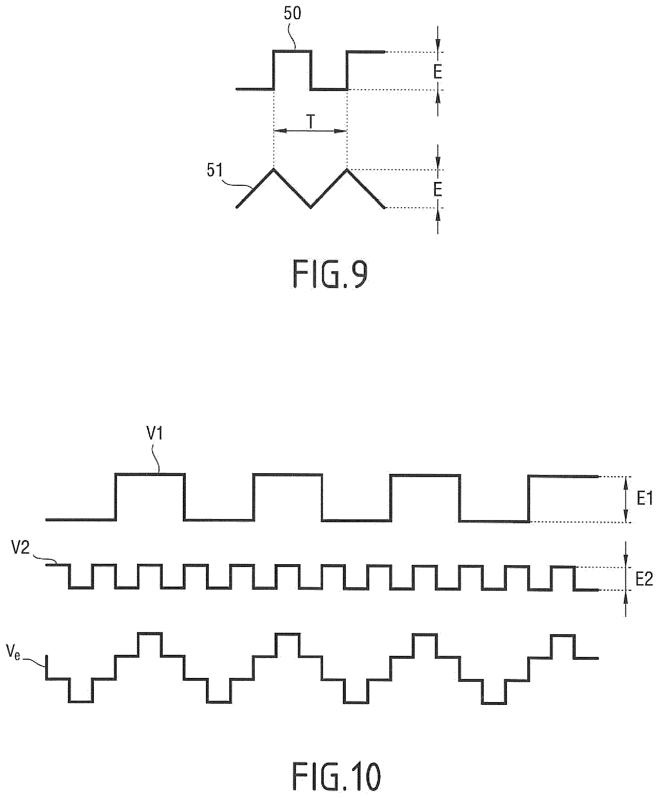

En référence à la figure 9, la décomposition spectrale d'un signal carré 50 d'amplitude E et de période T est : $X(t)=4.E/\Pi.[\sin(\omega t)+1/3.\sin(3\omega t)+1/5.\sin(5\omega t)+...]$, avec $\omega=2\Pi/T$.

La décomposition spectrale d'un signal triangulaire 51 d'amplitude E et de période T est : $X(t)=8.E/\Pi^2.[\sin(\omega t)-1/3^2.\sin(3\omega t)+1/5^2.\sin(5\omega t)-...]$, avec $\omega=2\Pi/T$.

Le signal triangulaire 51 comporte donc une composante harmonique d'ordre 3 négative.

En référence à la figure 10, l'addition d'une première tension V1 de forme rectangulaire et d'une deuxième tension V2 de forme rectangulaire, permet, lorsque l'amplitude de la première tension V1 et de la deuxième tension V2 sont correctement réglées, d'obtenir une tension d'excitation Ve de forme générale triangulaire dont la composante harmonique d'ordre 3 est négative.

Le phénomène de saturation du noyau magnétique 12 va rapprocher la forme d'onde du courant induit d'asservissement Iia de la forme d'onde d'un signal carré. En approchant de la saturation, l'amplitude de la composante harmonique d'ordre 3 du courant induit d'asservissement Iia va donc tendre vers zéro, puis devenir négative, conformément à la décomposition d'un signal carré. On définit ainsi une commande de tension d'excitation Ve par asservissement sur le point d'annulation de la composante harmonique d'ordre 3 du courant induit d'asservissement Iia.

On peut trouver par calcul ce point particulier de régulation.

La première tension V1 présente la décomposition spectrale suivante, en fonctions sinusoïdales : $X1(t)=4.E1/\Pi.[\sin(\omega 0t)+1/3.\sin(3\omega 0t)+1/5.\sin(5\omega 0t)+...]$.

La deuxième tension V2 présente la décomposition spectrale suivante, en fonctions sinusoïdales : $X2(t)=4.E2/\Pi.[\sin(3\omega 0t)+1/3.\sin(9\omega 0t)+1/5.\sin(15\omega 0t)+...]$.

La composante harmonique d'ordre 3 de la somme entre, d'une part, la décomposition spectrale de la première tension V1 et, d'autre part, la deuxième décomposition spectrale de la deuxième tension V2 est égale à :

$$4/\Pi.(E1/3.\sin(3\omega 0t)+E2.\sin(3\omega 0t).$$

La composante harmonique d'ordre 3 est donc nulle pour E1=-3.E2.

L'asservissement de la tension d'excitation Ve consiste à asservir l'amplitude de la deuxième tension V2. On joue donc sur l'amplitude de la deuxième tension V2 pour contrôler la tension d'excitation Ve de manière à annuler la composante de fréquence 3.f0 du courant induit d'asservissement Iia.

La commande de tension d'excitation Ve recherchée devra donc, avant saturation du noyau magnétique 12, comporter un niveau d'excitation relative par la composante harmonique d'ordre 3 donnant une résultante faiblement négative après démodulation par le démodulateur synchrone d'asservissement 40 pour pouvoir, lors de la saturation, passer par 0 puis devenir négative. C'est ce point particulier qu'il faut ajuster pour rechercher le meilleur compromis de gain de la fonction de transfert, qui correspond au point de fonctionnement optimal et au coude 9 de la fonction de transfert visible sur la figure 1.

On note le signal 2H de fréquence 2.f0 et le signal 3H de fréquence 3.f0 sont périodiquement inversés en phase, ici à une fréquence de 10kHz. Les décalages en opposition de phase sont moyennés par le premier correcteur proportionnel intégral 37 et par le deuxième correcteur proportionnel intégral 44, et donc annulés. Cette fonction d'inversion de phase à 10kHz permet de compenser les déséquilibres des voies de mesure et d'asservissement, qui résultent des imperfections des composants analogiques utilisés. On améliore ainsi la précision du réglage du capteur à vanne de flux 10 sur le point de fonctionnement optimal, et donc la précision globale du capteur à vanne de flux 10 lui-même.

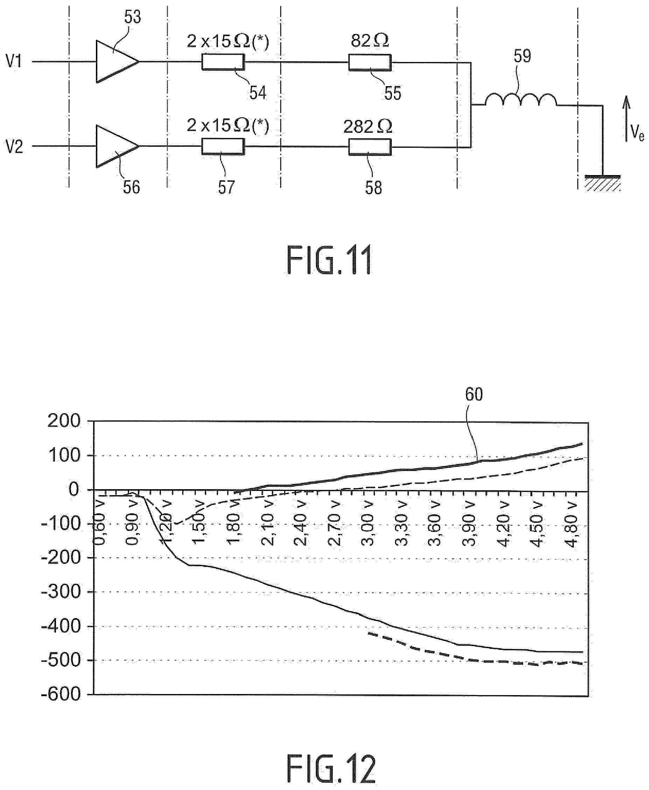

En référence à la figure 11, on utilise pour régler la tension d'excitation Ve un premier amplificateur 53 monté en buffer, deux premières résistances de sortie 54 de 15$\Omega$ chacune, une première résistance de réglage 55, un deuxième amplificateur 56 monté en buffer, deux deuxièmes résistances de sortie 57 de 15$\Omega$ chacune et une deuxième résistance de réglage 58. On applique ainsi sur une charge 59 une tension d'excitation telle que E1=2,78.E2. La valeur 2.78 est inférieure à 3, et donc le niveau de la composante harmonique d'ordre 3 de la tension d'excitation Ve est supérieur à celui d'un signal carré, ce qui correspond à un signal démodulé négatif.

En référence à la figure 12, la composante harmonique de la tension 60 en sortie du démodulateur synchrone d'asservissement 40 s'annule pour une tension d'excitation proche de 3V et devient positive au-delà. Le passage par zéro correspond donc au point de fonctionnement optimal du capteur de courant à vanne de flux 10. En asservissant le courant induit d'asservissement Iia sur ce point de passage par zéro, la fonction de transfert du capteur de courant à vanne de flux selon l'invention 10 reste dans le coude 9 de la figure 1.

Le capteur de courant à vanne de flux 10 présente un certain nombre d'avantages par rapport aux capteurs de courant à vanne de flux existants.

L'amélioration de la régulation du point de fonctionnement grâce à la démodulation par le démodulateur synchrone d'asservissement 40 permet d'obtenir une meilleure immunité aux bruits.

De plus, l'utilisation des démodulateurs synchrones permet de fonctionner à haute fréquence, ce qui autorise une bande passante importante du courant à mesurer Im tout en conservant une très bonne immunité aux perturbations électromagnétiques externes.

Comme la mesure se fait toujours dans le point de fonctionnement optimal correspondant au coude 9 de saturation, la sensibilité du capteur de courant à vanne de flux 10 est constante dans la plage de température. La précision du capteur de courant à vanne de flux 10 est donc bonne dans une plage importante de température.

Le capteur de courant à vanne de flux 10 est insensible aux dérives en fabrication de certaines caractéristiques du noyau magnétique 12. En particulier, les caractéristiques de perméabilité magnétique des noyaux magnétiques classiques, qui ne sont pas prévus pour être utilisés dans leur zone de saturation, sont très disparates. L'asservissement précis du point de fonctionnement permet de corriger ces dispersions. On peut donc utiliser des noyaux magnétiques standards, ce qui réduit les contraintes industrielles de fabrication du noyau magnétique, et donc le coût du capteur de courant à vanne de flux 10. On peut ainsi utiliser par exemple un noyau magnétique en ferrite utilisé classiquement dans des convertisseurs d'alimentation et pour certaines fonctions en radioélectricité.

On note par ailleurs que le capteur de courant à vanne de flux 10 présente une architecture transposable vers des solutions numériques pour améliorer la reproductibilité et donc la fabrication du capteur de courant à vanne de flux 10. Ainsi, la tension d'excitation Ve peut être produite par un convertisseur analogique numérique rapide. De même, les démodulateurs synchrones de mesure 32 et d'asservissement 40 peuvent être mis en œuvre sur un composant numérique (par exemple, sur un FPGA). La démagnétisation peut aussi se faire via un convertisseur numérique analogique.

On note qu'il serait possible d'utiliser non pas un seul mais deux noyaux magnétiques. Le deuxième noyau magnétique recevrait la même excitation que le circuit de mesure, mais en opposition de phase, pour annuler le flux directement au niveau du conducteur sur lequel circule le courant à mesurer.

Bien entendu, l'invention n'est pas limitée au mode de réalisation décrit mais englobe toute variante entrant dans le champ de l'invention telle que définie par les revendications.

## Revendications

**1.** Capteur de courant à vanne de flux comprenant un noyau magnétique (12) qui s'étend autour d'un conducteur (11) sur lequel circule un courant à mesurer (Im), un bobinage d'excitation (13), un module d'excitation (20) relié au bobinage d'excitation et destiné à générer une tension d'excitation (Ve) aux bornes du bobinage d'excitation, un bobinage de mesure (14) dans lequel circule un courant induit de mesure (Iim), un démodulateur synchrone de mesure (32) relié au bobinage de mesure et destiné à multiplier le courant induit de mesure par un signal de démodulation de fréquence 2.f0 pour obtenir une tension image du courant à mesurer, **caractérisé en ce que** la tension d'excitation (Ve) est obtenue à partir d'une première tension (V1) de fréquence f0 et d'une deuxième tension (V2) de fréquence 3.f0, **en ce que** le capteur de courant à vanne de flux comporte en outre un bobinage d'asservissement (15) distinct du bobinage d'excitation et dans lequel circule un courant induit d'asservissement, et un démodulateur synchrone d'asservissement (40) relié au bobinage d'asservissement et destiné à multiplier le courant induit d'asservissement par un signal de démodulation de fréquence 3.f0, et **en ce que** le démodulateur synchrone d'asservissement est relié au module d'excitation pour asservir la tension d'excitation de manière à annuler une composante de fréquence 3.f0 du courant induit d'asservissement.

**2.** Capteur de courant à vanne de flux selon la revendication 1, dans lequel la première tension (V1) et la deuxième tension (V2) sont des tensions rectangulaires.

**3.** Capteur de courant à vanne de flux selon la revendication 1, dans lequel la tension d'excitation (Ve) présente une forme générale triangulaire.

4. Capteur de courant à vanne de flux selon la revendication 1, dans lequel l'asservissement de la tension d'excitation consiste à asservir l'amplitude de la deuxième tension (V2).

5. Capteur de courant à vanne de flux selon la revendication 1, dans lequel le signal de démodulation de fréquence 2.f0 est un signal en Cos2ω0t, où ω0=2Πf0.

6. Capteur de courant à vanne de flux selon la revendication 1, comprenant en outre un bobinage de démagnétisation (16) dans lequel circule un courant de démagnétisation (Id) qui est asservie à partir de la tension image du courant à mesurer pour compenser un flux magnétique produit par le courant à mesurer (Im).

**Patentansprüche**

1. Fluxgate-Stromsensor, umfassend einen Magnetkern (12), der sich um einen Leiter (11) herum erstreckt, auf dem ein zu messender Strom (Im) fließt, eine Erregerwicklung (13), ein Erregermodul (20), das mit der Erregerwicklung verbunden und dazu bestimmt ist, eine Erregerspannung (Ve) zu erzeugen, die eine Frequenzkomponente f0 an den Klemmen der Erregerwicklung umfasst, eine Messwicklung (14), in der ein induzierter Messstrom (Iim) fließt, ein Mess-Synchrondemodulator (32), der mit der Messwicklung verbunden und dazu bestimmt ist, den induzierten Messstrom mit einem Demodulationssignal der Frequenz 2.f0 zu multiplizieren, um ein Spannungsbild des zu messenden Stroms zu erhalten, **dadurch gekennzeichnet, dass** die Erregerspannung (Ve) aus einer ersten Spannung (V1) der Frequenz f0 und einer zweiten Spannung (V2) der Frequenz 3.f0 erhalten wird, dass der Fluxgate-Stromsensor ferner eine Regelwicklung (15) umfasst, die von der Erregerwicklung getrennt ist und in der ein induzierter Regelstrom fließt, und einen Regel-Synchrondemodulator (40), der mit der Regelwicklung verbunden und dazu bestimmt ist, den induzierten Regelstrom mit einem Demodulationssignal der Frequenz 3.f0 zu multiplizieren, und dass der Regel-Synchrondemodulator (40) mit dem Erregermodul verbunden ist, um die Erregerspannung derart zu regeln, dass eine Frequenzkomponente 3.f0 des induzierten Regelstroms gelöscht wird.

2. Fluxgate-Stromsensor nach Anspruch 1, bei dem die erste Spannung (V1) und die zweite Spannung (V2) Rechteckspannungen sind.

3. Fluxgate-Stromsensor nach Anspruch 1, bei dem die Erregerspannung (Ve) eine allgemeine dreieckige Form aufweist.

4. Fluxgate-Stromsensor nach Anspruch 1, bei dem die Regelung der Erregerspannung darin besteht, die Amplitude der zweiten Spannung (V2) zu regeln.

5. Fluxgate-Stromsensor nach Anspruch 1, bei dem das Demodulationssignal der Frequenz 2.f0 ein Signal mit $\cos2\omega0t$ ist, wobei $\omega0=2\pi f0$ ist.

6. Fluxgate-Stromsensor nach Anspruch 1, ferner umfassend eine Entmagnetisierungswicklung (16), in der ein Entmagnetisierungsstrom (Id) fließt, der ausgehend von dem Spannungsbild des zu messenden Stroms geregelt wird, um einen von dem zu messenden Strom (Im) erzeugten Magnetfluss zu kompensieren.

**Claims**

1. A fluxgate current sensor comprising a magnetic core (12) that extends around a conductor (11) conveying a current (Im) for measuring, an excitation coil (13), an excitation module (20) connected to the excitation coil in order to generate an excitation voltage (Ve) across the terminals of the excitation coil, a measurement coil (14) conveying an induced measurement current (Iim), and a measurement synchronous demodulator (32) connected to the measurement coil for the purpose of multiplying the induced measurement current by a demodulation signal of frequency $2f_0$ in order to obtain an image voltage that is the image of the current for measuring, the sensor being **characterized in that** the excitation voltage (Ve) is obtained from a first voltage (V1) of frequency $f_0$ and from a second voltage (V2) of frequency $3f_0$, **in that** the fluxgate current sensor further includes a servo-control coil (15) distinct from the excitation coil and conveying an induced servo-control current, and a servo-control synchronous demodulator (40) connected to the servo-control coil for the purpose of multiplying the induced servo-control current by a demodulation signal of frequency $3f_0$, and **in that** the servo-control synchronous demodulator is connected to the excitation module in order to servo-control the excitation voltage in such a manner as to cancel the component of frequency $3f_0$ in the

induced servo-control current.

2. A fluxgate current sensor according to claim 1, wherein the first voltage (V1) and the second voltage (V2) are rectangular voltages.

3. A fluxgate current sensor according to claim 1, wherein the excitation voltage (Ve) represents a generally triangular waveform.

4. A fluxgate current sensor according to claim 1, wherein the excitation voltage is servo-controlled by servo-controlling the amplitude of the second voltage (V2) .

5. A fluxgate current sensor according to claim 1, wherein the demodulation signal of frequency 2fo is a $\cos 2\omega_0 t$ signal, where $\omega_0 = 2\pi f_0$.

6. A fluxgate current sensor according to claim 1, further including a demagnetization coil (16) conveying a demagnetization current (Id) that is servo-controlled from the voltage that is the image of the current for measuring in order to compensate for magnetic flux produced by the current (Im) for measuring.

EP 3 555 642 B1

## FIG.1

$B$ (T)

$\Delta B$

9

$H$ (At/m)

$\Delta H$

## FIG.2

2

5

3

1

4

$I_M$

8

Asservissement d'amplitude du courant

6

Courant de démagnétisation

Asservissement de la démagnétisation

## FIG.3

$V_e$

$I_e$

FIG.4

FIG.5

FIG.6

FIG.7

FIG.8

EP 3 555 642 B1

FIG.9

FIG.10

13

FIG.11

FIG.12

**EP 3 555 642 B1**

**RÉFÉRENCES CITÉES DANS LA DESCRIPTION**

**Documents brevets cités dans la description**

- WO 2014047644 A2